# EUROPEAN PATENT APPLICATION

(11) **EP 4 572 559 A2**
(43) Date of publication of application: **18.06.2025**
(21) Application number: 24215020.9
(22) Date of filing: 25.11.2024
(51) Int. Cl.: H10D 30/01, H10D 30/66, H10D 62/13, H10D 62/17

(54) **POWER DEVICE**

(30) Priority: 14.12.2023 CN 202311722697; 27.09.2024 WO PCT/CN2024/121730
(71) Applicant: HUNAN SAN'AN SEMICONDUCTOR CO., LTD., Changsha, Hunan (CN)
(72) Inventor: Li, Lijun, Changsha,Hunan (CN); Wang, Min, Changsha,Hunan (CN); Zhou, Hao, Changsha,Hunan (CN); Guo, Yuanxu, Changsha,Hunan (CN); Gong, Wentao, Changsha,Hunan (CN); Liu, Jie, Changsha,Hunan (CN); Shi, Rou, Changsha,Hunan (CN)
(74) Representative: Herrero & Asociados, S.L.

(57) **Abstract**

A power device is provided. In the power device, by embedding a lateral gate structure into the power device, channels in doped regions are still lateral conductive channel in an on state of the power device, so that a lateral spacing between a gate electrode and front metal is reduced, and a cell size of the power device can be effectively reduced in a horizontal direction.

## Description

### TECHNICAL FIELD

The present invention relates to the technical field of semiconductors, and particularly to a power device.

### BACKGROUND

A silicon carbide metal-oxide-semiconductor field-effect transistor (MOSFET) has a wide application prospect in the field of higher power and higher current because of its excellent switching characteristics and material characteristics. In recent years, the performance of a planar SiC MOSFET has been greatly optimized, and various manufacturers optimize a specific on-resistance by optimizing a process platform and structural design such as cell size design and ion implantation design.

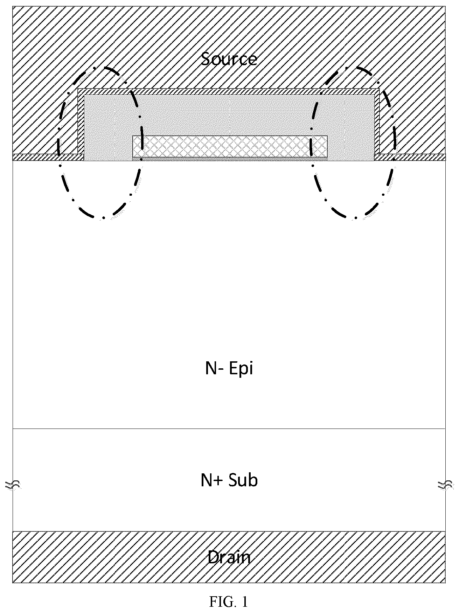

A schematic diagram of a cell structure of a conventional planar SiC MOSFET is illustrated in FIG. 1. A cell size of the planar SiC MOSFET is mainly limited by the following three dimensions: a size of ohmic contact, a size of a polysilicon gate electrode and a spacing between a gate electrode and a source metal. Specifically, if the spacing between the gate electrode and the source metal is reduced, the risk of gate-source short circuit of the device will increase, therefore, the spacing between the gate electrode and the source metal should not be too small, which has become one of the important reasons for limiting the cell size of the planar SiC MOSFET to continue to shrink. In the current mainstream products, the spacing between the gate electrode and the source metal accounts for 20%-30% of a length of a cell pitch of the planar SiC MOSFET, which is not conducive to the miniaturization of the planar SiC MOSFET, and at the same time makes it difficult to increase a number of chips on a single wafer, and thereby increases a production cost of the planar SiC MOSFET.

### SUMMARY

An objective of the present invention includes, for example, providing a power device that can effectively reduce a cell size of the power device, thereby reducing an area of a chip.

Specifically, doped regions are disposed in a semiconductor epitaxial layer, a trench is defined between the doped regions, a gate electrode is buried in the trench, the gate electrode is insulated from the doped regions and the semiconductor epitaxial layer by an insulating medium, an electrode layer is covered on the insulating medium, and the electrode layer is insulated from the gate electrode and forms ohmic contact with the doped regions. Compared with the related art, by arranging the trench and arranging the gate electrode in the trench, a lateral spacing between the gate electrode and the electrode layer is reduced, and a cell size of the power device can be effectively reduced in a horizontal direction. For example, compared with the existing structure in the background, the invention can reduce the cell size by 20%-30%, greatly reducing an area of a corresponding chip including the power device, thus increasing a number of chips produced on a single wafer by 20%-30% and greatly reducing a production cost of the power device.

### BRIEF DESCRIPTION OF DRAWINGS

It should be understood that the following accompanying drawings merely show some embodiments of the present invention, so they should not be regarded as limiting the scope of protection of the present invention. For those skilled in the art, other related drawings can be obtained according to these accompanying drawings without creative work.
FIG. 1 illustrates a schematic structural diagram of the related art.
FIG. 2 illustrates a schematic diagram of a power device according to an embodiment of the present invention.
FIG. 3 illustrates a partial structural diagram of a power device according to an embodiment of the present invention.
FIG. 4 illustrates a schematic diagram of a power device with a transition arc surface according to an embodiment of the present invention.
FIG. 5 illustrates a schematic diagram of a power device with a thinner insulating medium according to an embodiment of the present invention.
FIG. 6 illustrates a schematic diagram of a power device with a transition inclined surface according to an embodiment of the present invention.
FIG. 7 illustrates a partial structural diagram of a power device according to an embodiment of the present invention.
FIG. 8 through FIG. 14 illustrate process flow charts of a manufacturing method of a power device according to an embodiment of the present invention.
FIG. 15 illustrates a schematic sectional view of a power device according to an embodiment of the present invention.
FIG. 16 illustrates a schematic diagram of a gate voltage division of the power device shown in FIG. 15 under a short-circuit withstand test condition.
FIG. 17 to 25 illustrate schematic process structures corresponding to a manufacturing method of the power device shown in FIG. 15.
FIG. 26 illustrates a schematic sectional view of a power device according to an embodiment of the present invention.

### DETAILED DESCRIPTION OF EMBODIMENTS

In order to make the objectives, technical solutions and advantages of the embodiments of the present invention clearly, the technical solutions in the embodiments of the present invention will be described clearly and completely in combination with the accompanying drawings. Apparently, the described embodiments are part of embodiments of the present invention, but not the whole embodiments. Components of the embodiments of the present invention generally described and illustrated in the drawings herein can be arranged and designed in various different configurations.

As disclosed in the background, as illustrated in FIG. 1, in the traditional planar MOSFET, the cell size of the chip is limited by a width of ohmic contact, a width of the polysilicon gate electrode and a spacing between the gate electrode and the ohmic contact. In order to ensure the absolute electrical isolation between the gate electrode and the source electrode, a spacing between the gate electrode and the ohmic contact should not be too small. At present, a spacing between a gate electrode and an ohmic contact of mainstream products of various companies can account for about 20%-30% of a cell size, which has become a major obstacle to limiting the cell size of the planar MOSFET to continue to shrink.

In order to solve the above problems, the present invention provides a novel buried gate SiC MOSFET power device 100 and a preparation method thereof. The power device 100 and the preparation method thereof will be described in detail below. It should be noted that features in the embodiments of the present invention can be combined with each other without conflict.

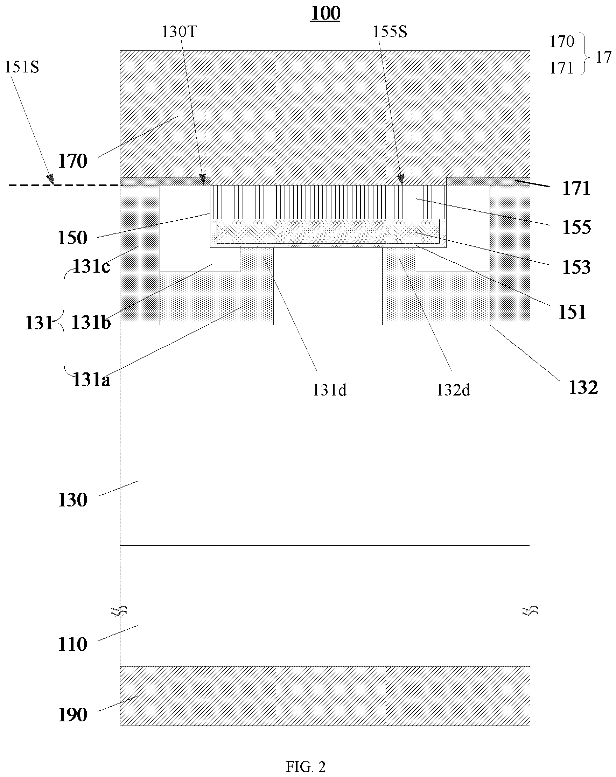

Referring to FIG. 2, an embodiment of the present invention provides a power device 100, which can effectively reduce a cell size of the power device and greatly reduce an area of a chip, thereby greatly reducing a production cost of the power device.

A power device 100 according to the embodiment of the present invention includes a substrate 110, a semiconductor epitaxial layer 130, a first doped region 131, a second doped region 132, a gate structure 150, and front metal 170. The semiconductor epitaxial layer 130 is disposed on the substrate 110. The first doped region 131 and the second doped region 132 are disposed in the semiconductor epitaxial layer 130. The gate structure 150 includes a trench 151, a gate electrode 153 and an insulating medium 155. The trench 151 is defined between the first doped region 131 and the second doped region 132 and is partially embedded in the first doped region 131 and the second doped region 132. The gate electrode 153 is disposed to be buried in the trench 151. The insulating medium 155 insulates the gate electrode 153 from the first doped region 131, the second doped region 132 and the semiconductor epitaxial layer 130. The front metal 170 is disposed on the semiconductor epitaxial layer 130 and the insulating medium 155 is covered by the front metal 170. The insulating medium 155 insulates the gate electrode 153 from the front metal 170, and an ohmic contact layer 171 is disposed between the front metal 170 and the first doped region 131 and between the front metal 170 and the second doped region 132. In an on state of the power device 100, a first channel 131d in the first doped region 131 and a second channel 132d in the second doped region 132 are configured as lateral conductive channels. In this embodiment, the first doped region 131 and the second doped region 132 are respectively specific implementations of doped regions at different positions in the semiconductor epitaxial layer 130. Channels in the corresponding doped regions include the first channel 131d in the first doped region 131 and the second channel 132d in the second doped region 132. The combination of the front metal 170 and the ohmic contact layer 171 is a specific implementation of an electrode layer 17, thereby realizing the ohmic contact between the electrode layer 17 and the doped regions.

It is worth noting that the power device 100 in this embodiment is specifically a buried gate SiC MOSFET structure. In this embodiment, the first doped region 131 and the second doped region 132 are disposed in the semiconductor epitaxial layer 130, a trench 151 is provided between the first doped region 131 and the second doped region 132, and the gate electrode 153 is disposed to be buried in the trench 151. At the same time, the gate electrode 153 is insulated from the first doped region 131, the second doped region 132 and the semiconductor epitaxial layer 130 by the insulating medium 155, the front metal 170 is covered on the insulating medium 155, the front metal 170 is insulated from the gate electrode 153, and the ohmic contact layer 171 is disposed between the front metal 170 and the first doped region 131 and between the front metal 170 and the second doped region 132. By arranging the trench 151 and burying the gate electrode 153 in the trench 151, a lateral spacing between the gate electrode 153 and the front metal 170 is reduced, and a cell size of the power device 100 can be effectively reduced in a horizontal direction. For example, compared with the existing structure in the background, this embodiment can reduce the cell size by 20%-30%, greatly reducing the area of the chip, thus increasing a number of chips produced on a single wafer by 20%.

It should be noted that the ohmic contact layer 171 can be obtained by depositing ohmic contact metal on a surface of the semiconductor epitaxial layer 130 and then tempering, so that a good ohmic contact layer can be formed. At the same time, it is necessary to remove the excess ohmic contact metal that has not reacted with the semiconductor epitaxial layer 130, that is, to remove the ohmic contact metal on a surface of the insulating medium 155. In an embodiment, the ohmic contact layer 171 may be a material with good electrical conductivity, such as a Ti/Cu layer. Of course, the ohmic contact layer 171 on the surface of the insulating medium 155 may also be left herein.

In an embodiment, a side of the substrate 110 facing away from the front metal 170 is also provided with a back metal 190, the front metal 170 is used as a source metal layer, and a back metal 190 is used as a drain electrode.

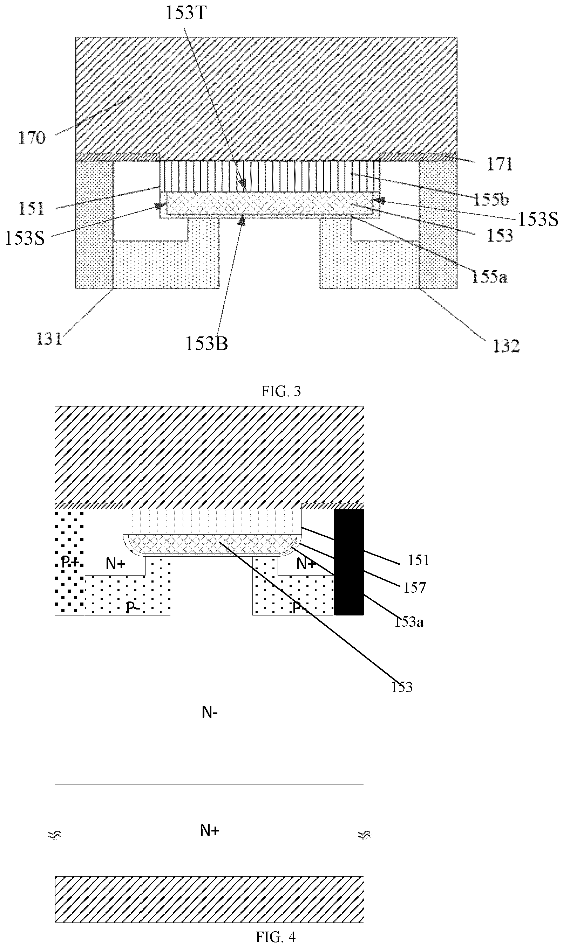

Referring to FIG. 3, in some embodiments, the gate electrode 153 includes a bottom surface 153B facing away from the front metal 170, a top surface 153T close to the front metal 170, and two opposite side surfaces 153S connecting the top surface 153T and the bottom surface 153B. The insulating medium 155 includes a gate oxide layer 155a and a dielectric layer 155b, which together surround the gate electrode 153. The gate oxide layer 155a covers the bottom surface 153B and two side surfaces 153S of the gate electrode 153. Specifically, the gate oxide layer 155a is prepared between the gate electrode 153 and the semiconductor epitaxial layer 130, and the gate electrode 153 may be made of polysilicon. After the trench 151 is formed, the gate oxide layer 155a and a doped polysilicon layer may be formed by thermal oxidation, and then the patterned gate electrode 153 may be formed by etching. During etching, the polysilicon layer and the gate oxide layer 155a around the trench 151 may be removed together and etched into the trench 151. Part of the polysilicon layer and the gate oxide layer 155a in the trench 151 are removed to form the gate oxide layer 155a and the gate electrode 153 as shown in the FIG. 3, and then the dielectric layer 155b is prepared.

It should be noted that the trench 151 in this embodiment adopts a horizontal channel, and the gate oxide layer 155a is generated by a thermal oxidation process, thereby ensuring compatibility with a planar MOSFET production process.

Referring to FIG. 4, in some embodiments, each of the side surfaces 153S of the gate electrode 153 includes an arc segment 153a, and the trench 151 is provided with a transition arc surface 157 adapted to (i.e., matched with) the arc segment 153a. Specifically, a side bottom of the gate electrode 153 is arc-shaped, and two ends of a bottom of the trench 151 are smooth arcs to a certain extent, which is beneficial to thermal oxidation to form the gate oxide layer 155a.

In some embodiments, a side of the gate electrode 153 is an arc segment 153a. That is, an entire side surface of the gate electrode 153 is in the shape of an arc surface, and the trench 151 is provided with a transition arc surface 157 adapted to the arc side wall of the gate electrode 153.

In some embodiments, a thickness of the gate oxide layer 155a covering the side surface 153S of the gate electrode 153 is equal to a thickness of the gate oxide layer 155a covering the bottom surface 153B of the gate electrode 153. It can be understood that for the conventional planar gate device, a thickness of the gate oxide layer is usually thinner than that of a dielectric layer used for insulating an ohmic contact and the gate electrode. Therefore, in this embodiment, the gate electrode 153 is buried in the trench 151, and at least the dimension that can be reduced in the lateral direction is a thickness difference between the dielectric layer and the gate oxide layer used for insulating the ohmic contact and the gate electrode.

With continued reference to FIG. 2 and FIG. 3, in order to ensure the insulation between the gate electrode 153 and the doped regions, thereby ensuring the reliability of the power device, in some embodiments, a thickness of the gate oxide layer 155a covering the side surface 153S of the gate electrode 153 is greater than a thickness of the gate oxide layer 155a covering the bottom surface 153B of the gate electrode 153. Specifically, the gate oxide layer 155a covers a bottom wall of the trench 151 and a part of a sidewall of the trench 151, and a thickness of the gate oxide layer 155a on the sidewall of the trench 151 is greater than a thickness of the gate oxide layer 155a on the bottom wall of the trench 151. In the process of forming the gate oxide layer 155a by thermal oxidation, the thickness of the gate oxide layer 155a on the sidewall of the trench 151 is naturally greater than a thickness of the gate oxide layer 155a on the bottom wall of the trench 151, thereby making the power device more reliable.

In some embodiments, the insulating medium 155 (specifically, a surface 155S of the insulating medium 155 facing away from the substrate 110) is flush with a plane 151S where a notch of the trench 151 is located. A spacing between a side of the dielectric layer 155b facing away from the substrate 110 and the substrate 110 may be equal to a spacing between a side of the semiconductor epitaxial layer 130 facing away from the substrate 110 and the substrate 110, so that the dielectric layer 155b is flush with the side of the semiconductor epitaxial layer 130 facing away from the substrate 110, which improves an overall flatness and is beneficial to the subsequent formation of the front metal 170. In addition, the dielectric layer 155b is flush with the side of the semiconductor epitaxial layer 130 facing away from the substrate 110, which can maximize a thickness of the dielectric layer 155b, ensure longitudinal electrical isolation between the gate electrode 153 and the front metal 170, and significantly reduce the cell size of the power device 100.

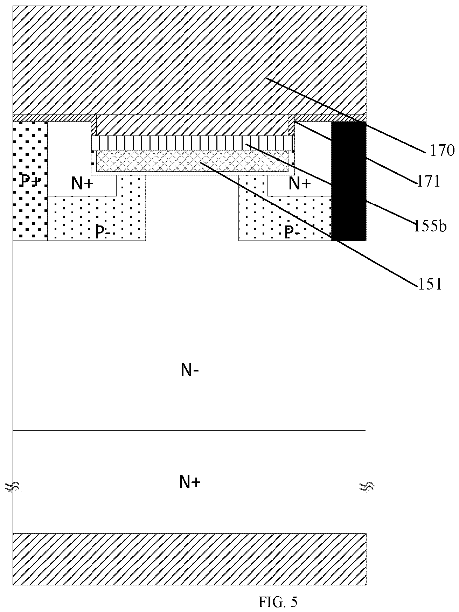

Referring to FIG. 5, in some embodiments, the insulating medium 155 (specifically, the surface 155S of the insulating medium 155 facing away from the substrate 110) is lower than the plane 151S where the notch of the trench 151 is located. Specifically, a spacing between a side of the dielectric layer 155b facing away from the substrate 110 and the substrate 110 is smaller than a spacing between a side of the semiconductor epitaxial layer 130 facing away from the substrate 110 and the substrate 110, the front metal 170 is disposed to extend into the trench 151, and the ohmic contact layer 171 extends to the sidewalls of the trench 151. Specifically, an upper boundary of the dielectric layer 155b is lower than a side surface of the semiconductor epitaxial layer 130 facing away from the substrate 110, so that the dielectric layer 155b is also confined in the trench 151.

In some embodiments, the front metal 170 extends into the trench 151, and the ohmic contact layer 171 extends to part of the sidewall of the trench 151. When the ohmic contact layer 171 is formed, the ohmic contact metal located on the sidewall of the trench 151 can be retained, so that the ohmic contact layer 171 can extend from the side surface of the semiconductor epitaxial layer 130 facing away from the substrate 110 to the sidewall of the trench 151, thereby increasing an area of the ohmic contact region and reducing the contact resistance.

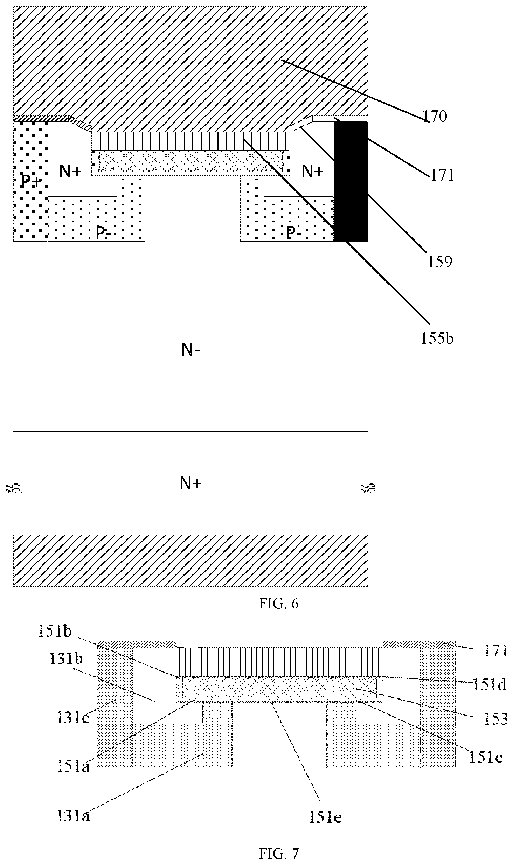

Referring to FIG. 6, in some embodiments, a notch edge of the trench 151 is an inclined surface 159, and the ohmic contact layer 171 extends onto the inclined surface 159. The inclined surface 159 extends from the sidewall of the trench 151 to a side surface of the semiconductor epitaxial layer 130 facing from the substrate 110, and the ohmic contact layer 171 extends onto the inclined surface 159 and covers the inclined surface 159. Specifically, the semiconductor epitaxial layer 130 on both sides of a top end of the trench 151 may be the inclined surface159 instead of a right angle, and the ohmic contact layer 171 also covers the inclined surface 159. By this arrangement, on the one hand, the molding difficulty of the trench 151 can be reduced, on the other hand, the area of the ohmic contact region can be increased and the contact resistance can be reduced.

Referring to FIG. 2, in some embodiments, the substrate 110 may be of a first conductivity type, the semiconductor epitaxial layer 130 is also of the first conductivity type, and a doping concentration of the substrate 110 is greater than that of the semiconductor epitaxial layer 130.

Hereinafter, taking the first conductive type as an example of N-type, the substrate 110 may be an N+ type doped layer, that is, heavily doped, and the substrate 110 can be a SiC substrate 110. The semiconductor epitaxial layer 130 is an N- type doped layer, that is, lightly doped, and the semiconductor epitaxial layer 130 may be made of SiC material, in which the first doped region 131 and the second doped region 132 are respectively formed on opposite sides of the trench 151.

Exemplarily, the first doped region 131 and the second doped region 132 each include a P- type ion implantation region 131a, an N+type ion implantation region 131b, and a P+type ion implantation region 131c, which are mutually abutted. The P+ type ion implantation region 131c is located at the outside of the semiconductor epitaxial layer 130. The P- type ion implantation region 131a and the N+ type ion implantation region 131b are both located on a side of the P+ type ion implantation region 131c facing towards the trench 151. The trench 151 extends to the P- type ion implantation region 131a and the N+ type ion implantation region 131b, and a part of the P- type ion implantation region 131a extends to a bottom wall of the trench 151.

It should be noted that P- type ion implantation refers to an ion implantation process with lower concentration P-type doping, N+ type ion implantation refers to an ion implantation process with higher concentration N-type doping, and P+ type ion implantation refers to an ion implantation process with higher concentration P-type doping. In this embodiment, the P- type ion implantation region 131a extends to the bottom wall of the trench 151, with the N+ type ion implantation region 131b and the N- type semiconductor epitaxial layer 130 on either side of an extension part of the P- type ion implantation region 131a to the bottom wall of the trench 151, as such, the P- type ion implantation region 131a forms a junction field-effect transistor (JFET) region, which protects the gate oxide layer 155a in a horizontal region and ensures the reliability of the gate oxide layer 155a during reverse voltage withstand of the power device 100.

Referring to FIG. 2 and FIG. 3 again, an embodiment of the present invention also provides another power device 100, which includes a substrate 110, a semiconductor epitaxial layer 130, a first doped region 131, a second doped region 132, a gate structure 150 and front metal 170. The first doped region 131 and the second doped region 132 are disposed in the semiconductor epitaxial layer 130. The gate structure 150 includes a trench 151, a gate electrode 153 and an insulating medium 155. The trench 151 is defined between the first doped region 131 and the second doped region 132 and is partially embedded in the first doped region 131 and the second doped region 132. The gate electrode 153 is disposed to be buried in the trench 151. The insulating medium 155 is disposed in the trench 151, and the insulating medium 155 insulates the gate electrode 153 from the first doped region 131, the second doped region 132, and the semiconductor epitaxial layer 130. The front metal 170 is disposed on the semiconductor epitaxial layer 130 and covers the insulating medium 155, with the insulating medium 155 insulating the gate electrode 153 from the front metal 170. An ohmic contact layer 171 is disposed between the front metal 170 and the first doped region 131 and between the front metal 170 and the second doped region 132. In an on state of the power device 100, a first channel 131d in the first doped region 131 and a second channel 132d in the second doped region 132 are configured as lateral conductive channels.

In some embodiments, the trench 151 includes a bottom wall and sidewalls, and the sidewalls and part of the bottom wall of the trench 151 are configured to be embedded in the first doped region 131 and the second doped region 132. The insulating medium 155 includes a gate oxide layer 155a and a dielectric layer 155b. The gate oxide layer 155a is disposed between the gate electrode 153 and the trench 151 and extends from the bottom wall of the trench 151 to a first sidewall 151b and a second sidewall 15 1d. The dielectric layer 155b covers the gate electrode 153 and extends to cover the gate oxide layer 155a on the first sidewall 151b and the second sidewall 151d. The gate oxide layer 155a is prepared between the gate electrode 153 and the semiconductor epitaxial layer 130. The gate electrode 153 may be made of polysilicon. After the trench 151 is formed, the gate oxide layer 155a and a doped polysilicon layer may be formed by thermal oxidation, and then the patterned gate electrode 153 can be formed by etching. During etching, the polysilicon layer and the gate oxide layer 155a around the trench 151 may be removed together and etched into the trench 151. Part of the polysilicon layer and the gate oxide layer 155a in the trench 151 are removed to form the gate oxide layer 155a and the gate electrode 153 as shown in the FIG. 3, and then the dielectric layer 155b is prepared.

Referring to FIG. 4, in some embodiments, a transition arc surface 157 is formed between the bottom wall of the trench 151 and each of the side walls of the trench 151. Each side surface of the gate electrode 153 includes an arc segment 153a adapted to the transition arc surface 157. Specifically, a side bottom of the gate electrode 153 is arc-shaped, and two ends of a bottom of the trench 151 are smooth arcs to a certain extent, which is beneficial to thermal oxidation to form the gate oxide layer 155a.

In some embodiments, a side of the gate electrode 153 is an arc segment 153a adapted to the transition arc surface 157. That is, an entire side surface of the gate electrode 153 is in the shape of an arc surface, and the trench 151 is provided with a transition arc surface 157 adapted to the arc side wall of the gate electrode 153.

Referring to FIG. 2 and FIG. 3 again, in some embodiments, a thickness of the gate oxide layer 155a between the bottom wall of the trench 151 and the gate electrode 153 is smaller than a thickness of the gate oxide layer 155a between the first sidewall 151b of the trench 151 and the gate electrode 153; and the thickness of the gate oxide layer 155a between the bottom wall of the trench 151 and the gate electrode 153 is smaller than a thickness of the gate oxide layer 155a between the second sidewall 151d of the trench 151 and the gate electrode 153. The gate oxide layer 155a covers the bottom wall and the sidewalls of the trench 151, and a thickness of the gate oxide layer 155a on the sidewall of the trench 151 is greater than a thickness of the gate oxide layer 155a on the bottom wall of the trench 151. In the process of forming the gate oxide layer 155a by thermal oxidation, the thickness of the gate oxide layer 155a on the sidewall of the trench 151 is naturally greater than a thickness of the gate oxide layer 155a on the bottom wall of the trench 151, thereby making the reliability risk of the device less.

In some embodiments of the present invention, a thickness of the gate oxide layer 155a between the bottom wall of the trench 151 and the gate electrode 153 may be smaller than a thickness of the gate oxide layer 155a between the first sidewall 151b of the trench 151 and the gate electrode 153; or, the thickness of the gate oxide layer 155a between the bottom wall of the trench 151 and the gate electrode 153 is smaller than a thickness of the gate oxide layer 155a between the second sidewall 151d of the trench 151 and the gate electrode 153.

Referring to FIG. 6, in some embodiments, the sidewall of the trench 151 near a notch of the trench 151 is configured as an inclined surface 159. The inclined surface 159 extends from the sidewall of the trench 151 to a side surface of the semiconductor epitaxial layer 130 facing from the substrate 110, and the ohmic contact layer 171 extends onto the inclined surface 159 and covers the inclined surface 159. Specifically, the semiconductor epitaxial layer 130 on both sides of a top end of the trench 151 may be the inclined surface159 instead of a right angle, and the ohmic contact layer 171 also covers the inclined surface 159. By this arrangement, on the one hand, the molding difficulty of the trench 151 can be reduced, on the other hand, the area of the ohmic contact region can be increased and the contact resistance can be reduced.

In some embodiments, the front metal 170 extends into the trench 151, and the ohmic contact layer extends onto the inclined surface 159. When the ohmic contact layer 171 is formed, the ohmic contact metal located on the inclined surface 159 can be retained, so that the ohmic contact layer 171 can extend from the side surface of the semiconductor epitaxial layer 130 facing away from the substrate 110 to the inclined surface 159, thereby increasing an area of the ohmic contact region and reducing the contact resistance.

Referring to FIG. 2 and FIG. 7, the embodiment of the present invention also provides another power device 100, including a substrate 110, a semiconductor epitaxial layer 130, a first doped region 131, a second doped region 132, a gate structure 150 and front metal 170. The semiconductor epitaxial layer 130 is disposed on the substrate 110. The first doped region 131 and the second doped region 132 are disposed in the semiconductor epitaxial layer 130. The first doped region 131 includes a first base region and a first source region disposed in the first base region. The second doped region 132 includes a second base region and a second source region disposed in the second base region. The gate structure 150 includes a trench 151, a gate electrode 153 and an insulating medium 155. The trench 151 includes a first bottom wall 151a at least disposed on the first base region, a first side wall 151b connected with the first source region, a second bottom wall 151c at least disposed on the second base region, and a second side wall 151d connected with the second source region. The gate electrode 153 is configured to be buried in the trench 151. The insulating medium 155 is disposed in the trench 151, and the insulating medium 155 is configured to insulate the gate electrode 153 from the first doped region 131, the second doped region 132 and the semiconductor epitaxial layer 130. The front metal 170 is disposed on the semiconductor epitaxial layer 130 and covers insulating medium 155. A dielectric layer 155b of the insulating medium 155 insulates the gate electrode 153 from the front metal 170, and an ohmic contact layer 171 is disposed between the front metal 170 and the first doped region 131 and between the front metal 170 and the second doped region 132. In this embodiment, the first doped region 131 and the second doped region 132 are respectively specific implementations of doped regions at different positions in the semiconductor epitaxial layer 130. Channels in the corresponding doped regions include the first channel 131d in the first doped region 131 and the second channel 132d in the second doped region 132. A base region in the doped regions includes the first base region in the first doped region 131 and the second base region in the second doped region 132, and a source region in the doped regions includes the first source region in the first doped region 131 and the second source region in the second doped region 132. The combination of the front metal 170 and the ohmic contact layer 171 is a specific implementation of an electrode layer 17, thereby realizing the ohmic contact between the electrode layer 17 and the doped regions.

It should be noted that the first base region is a P- type ion implantation region 131a in the first doped region 131, the first source region is an N+ type ion implantation region 131b in the first doped region 131, the second base region is the P- type ion implantation region 131a in the second doped region 132, and the second source region is an N+ type ion implantation region 131 in the second doped region 132.

In an embodiment, the trench 151 further includes a third bottom wall 151e disposed in the semiconductor epitaxial layer 130, and two ends of the third bottom wall 151e are respectively connected with the first bottom wall 151a and the second bottom wall 151c. The first bottom wall 151a, the second bottom wall 151c and the third bottom wall 151e together constitute the bottom wall of the trench 151.

In some embodiments, the first bottom wall 151a, the second bottom wall 151c, and the third bottom wall 151e are on the same horizontal line. By arranging the first bottom wall 151a, the second bottom wall 151c, and the third bottom wall 151e on the same plane, the bottom wall of the trench 151 can be arranged horizontally, which helps to achieve planarization and is beneficial for the subsequent preparation of the gate oxide layer 155a of the insulating medium 155 and the gate electrode 153.

Referring to FIG. 2 and FIG. 3 again, an embodiment of the present invention also provides another power device 100, including a substrate 110, a semiconductor epitaxial layer 130, a first doped region 131, a second doped region 132, a gate structure 150 and front metal 170. The semiconductor epitaxial layer 130 is disposed on the substrate 110. The first doped region 131 and the second doped region 132 are disposed in the semiconductor epitaxial layer 130. The gate structure 150 includes a trench 151, a gate electrode 153 and an insulating medium 155. The trench 151 is provided between the first doped region 131 and the second doped region 132 and is partially embedded in the first doped region 131 and the second doped region 132. The gate electrode 153 is disposed to be buried in the trench 151. The insulating medium 155 insulates the gate electrode 153 from the first doped region 131, the second doped region 132, and the semiconductor epitaxial layer 130. The front metal 170 is disposed on the semiconductor epitaxial layer 130 and covers the insulating medium 155, with the insulating medium 155 configured to insulate the gate electrode 153 from the front metal 170. An ohmic contact layer 171 is configured between the front metal 170 and the first doped region 131 and between the front metal 170 and the second doped region 132. The insulating medium 155 includes a gate oxide layer 155a disposed between the gate electrode 153 and the trench 151, and a projection of the gate oxide layer 155a on a surface of the semiconductor epitaxial layer 130 is connected with a projection of the ohmic contact layer 171 on the surface of the semiconductor epitaxial layer 130.

In some embodiments, the trench 151 includes sidewalls and a bottom wall, and the sidewalls and a part of the bottom wall of the trench 151 are configured to be embedded in the first doped region 131 and the second doped region 132.

In some embodiments, referring to FIG. 2, FIG. 4 and FIG. 6, a projection of the gate oxide layer 155a on the surface of the semiconductor epitaxial layer 130 (specifically, a top surface 130T of the epitaxial layer 130) is adjacent to a projection of the ohmic contact layer 171 on the surface of the semiconductor epitaxial layer 130, and a spacing between the projection of the gate oxide layer 155a on the surface of the semiconductor epitaxial layer 130 and the projection of the ohmic contact layer 171 on the surface of the semiconductor epitaxial layer 130 is zero. The ohmic contact layer 171 extends to the sidewalls of the trench 151, thereby ensuring complete bonding between the ohmic contact layer 171 and the gate oxide layer 155a in a projection direction.

In some embodiments, the ohmic contact layer 171 is connected with an end of each sidewall of the trench 151 facing away from the bottom wall. Specifically, the ohmic contact layer 171 extends to a top edge of the trench 151.

Referring to FIG. 6, in some embodiments, the sidewall of the trench 151 near a notch of the trench 151 is configured as an inclined surface 159. The inclined surface 159 extends from the sidewall of the trench 151 to a side surface of the semiconductor epitaxial layer 130 facing from the substrate 110, and the ohmic contact layer 171 extends onto the inclined surface 159 and covers the inclined surface 159. Specifically, the semiconductor epitaxial layer 130 on both sides of a top end of the trench 151 may be the inclined surface159 instead of a right angle, and the ohmic contact layer 171 also covers the inclined surface 159. By this arrangement, on the one hand, the molding difficulty of the trench 151 can be reduced, on the other hand, the area of the ohmic contact region can be increased and the contact resistance can be reduced.

In some embodiments, referring to FIG. 5, a projection of the gate oxide layer 155a on the surface of the semiconductor epitaxial layer 130 partially overlaps with a projection of the ohmic contact layer 171 on the surface of the semiconductor epitaxial layer 130. Specifically, when the insulating medium 155 is lower than a notch where the trench 151 is located, because the front metal 170 is partially embedded in the trench 151 and located on a surface of the insulating medium 155, the ohmic contact layer 171 extends onto the insulating medium 155 along a surface of the semiconductor epitaxial layer 130, so that the ohmic contact layer 171 can extend from a side surface of the semiconductor epitaxial layer 130 facing away from the substrate 110 onto the dielectric layer 155b, thereby increasing the area of the ohmic contact region.

Referring to FIG. 5, in some embodiments, the ohmic contact metal (i.e., the ohmic contact layer 171) extends into the trench 151, and at least part of an extension portion of the ohmic contact layer 171 extending into the trench 151 is in the same plane as the gate oxide layer 155a. Specifically, the extension portion of the ohmic contact layer 171 covers a part of each sidewall of the trench 151, so that the extension portion is located on the same vertical sidewall as the gate oxide layer 155a.

In some embodiments, the gate electrode 153 includes a bottom surface 153B facing away from the front metal 170, a top surface 153T near the front metal 170, and two opposite side surfaces 153S connecting the top surface 153T and the bottom surface 153B. A projection of the gate oxide layer 155a between the side surface 153S of the gate electrode 153 and the side surface of the trench 151 on a plane 151S where a notch of the trench 151 is located overlaps with a projection of the extension portion of the ohmic contact layer 171 into the trench 151 on the plane where the notch of the trench 151 is located.

An embodiment of the present invention also provides a preparation method of the power device 100, which is used for preparing the aforementioned power device 100, and the preparation method includes steps S1 to S7.

In step S1, a semiconductor epitaxial layer 130 is grown on a substrate 110.

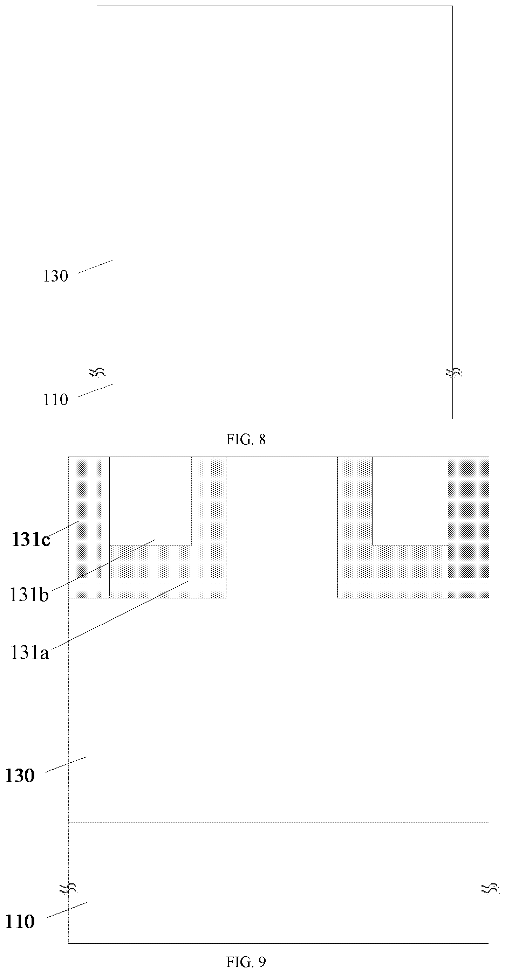

Specifically, referring to FIG. 8, an N- type semiconductor epitaxial layer 130 is grown on an N+ type substrate 110, and a corresponding growth mode is a vapor phase epitaxial process.

In step S2, a first doped region 131 and a second doped region 132 are formed by local ion implantation on a side of the semiconductor epitaxial layer 130 facing from the substrate 110.

Specifically, referring to FIG. 9, after the N- type semiconductor epitaxial layer 130 is formed, ion implantation is performed locally on a surface of the N- type semiconductor epitaxial layer 130, thereby forming a P- type ion implantation region 131a, an N+ type ion implantation region 131b and a P+ type ion implantation region 131c. The P+ type ion implantation region 131c is located at the outside of the semiconductor epitaxial layer 130. The P- type ion implantation region 131a and the N+ type ion implantation region 131b are both located on a side of the P+ type ion implantation region 131c facing towards an outer side of the semiconductor epitaxial layer 130.

In step S3, etching is performed on a side of the semiconductor epitaxial layer 130 facing away from the substrate 110 to form a trench 151.

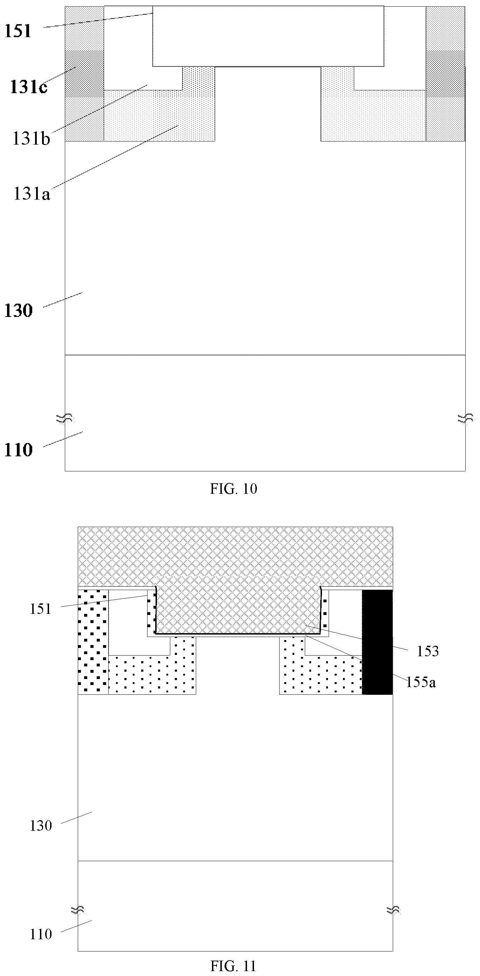

Specifically, referring to FIG. 10, the trench 151 may be defined through an etching process on the structure shown in FIG. 9. The trench 151 is embedded between the first doped region 131 and the second doped region 132. In an embodiment, the trench 151 extends to the P- type ion implantation region 131a and the N+ type ion implantation region 131b in the first doped region 131 and the second doped region 132, and a portion of the P- type ion implantation region 131a extends to the bottom wall of the trench 151, as such, the P- type ion implantation region 131a forms a junction field-effect transistor (JFET) region.

In step S4, a gate electrode 153 is formed in the trench 151.

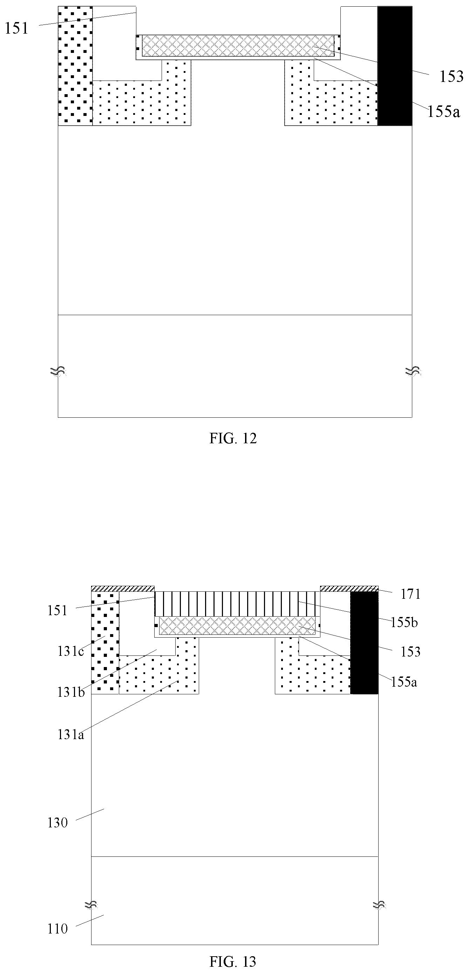

A thickness of the gate electrode 153 is smaller than a depth of the trench 151. In actual preparation of the gate electrode 153, referring to FIG. 11, a gate oxide layer 155a and a doped polysilicon layer are first formed by thermal oxidation, and then a patterned gate electrode 153 is formed by etching, as shown in FIG. 12.

It should be noted that in the process of forming the gate oxide layer 155a by thermal oxidation, both the sidewalls and the bottom wall of the trench 151 are covered with a layer of gate oxide layer 155a, and a thickness of the gate oxide layer 155a on the sidewall is greater than that a thickness of the gate oxide layer 155a on the bottom wall.

In step S5, a dielectric layer 155b is deposited in the trench 151.

Specifically, referring to FIG. 13, the dielectric layer 155b is coated outside the gate electrode 153. On the basis of the above structure in FIG. 13, a layer of material of an insulating medium 155 is deposited on an upper surface of the gate electrode, and then thinned by etching, so that an upper surface of the dielectric layer 155b is not higher than a surface of the semiconductor epitaxial layer 130. Then, ohmic contact metal is deposited on the surface of the semiconductor epitaxial layer 130 and then tempered, so as to form a good ohmic contact layer 171, and excess ohmic contact metal that has not reacted with the semiconductor epitaxial layer 130 is removed, so that surfaces of the semiconductor epitaxial layer 130 around the trench 151 are covered with a layer of ohmic contact layer 171.

In step S6, front metal 170 is formed on a side of the semiconductor epitaxial layer 130 facing away from the substrate 110.

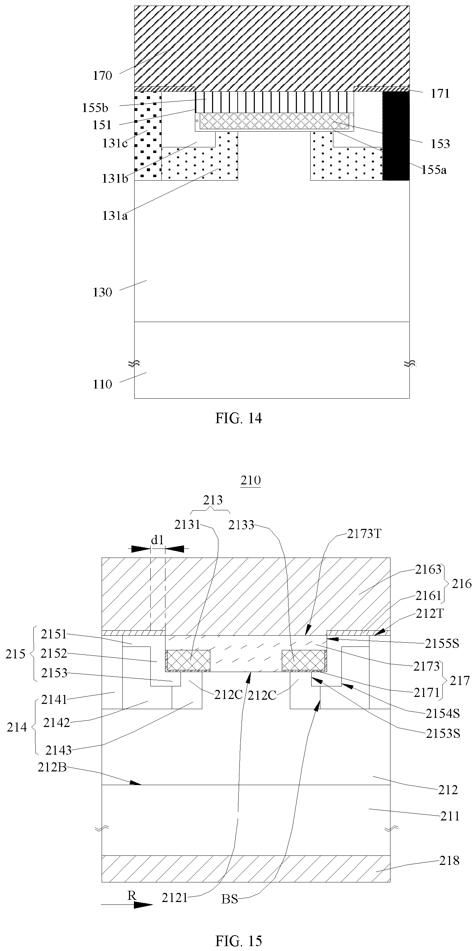

The front metal 170, as a source metal, covers the dielectric layer 155b. Specifically, referring to FIG. 14, based on the structure in FIG. 13, a thickened front metal 170 is deposited on an upper surface of the semiconductor epitaxial layer 130, and a source region is formed by etching and patterning.

In step S7, a back metal 190 is formed on a side of the substrate 110 facing away from the semiconductor epitaxial layer 130.

Specifically, please continue to refer to FIG. 2. After the back surface of the substrate 110 is thinned, a back surface metal 190 is deposited, and after patterning, a drain electrode is formed. After thinning the backside of the substrate 110, the back metal 190 is deposited on the substrate 110, and then the back metal 190 is patterned to form a drain electrode.

To sum up, in this embodiment, the first doped region 131 and the second doped region 132 are disposed in the semiconductor epitaxial layer 130, and the trench 151 is provided between the first doped region 131 and the second doped region 132, so that the gate electrode 153 can be buried in the trench 151. At the same time, the gate electrode 153 is insulated from the first doped region 131, the second doped region 132 and the semiconductor epitaxial layer 130 by the insulating medium 155. Finally, the front metal 170 is covered on the insulating medium 155, and the front metal 170 is insulated from the gate electrode 153, and the ohmic contact layer 171 is disposed between the front metal 170 and the first doped region 131 and between the front metal 170 and the second doped region 132. By arranging the trench 151 and burying the gate electrode 153 in the trench 151, a lateral spacing between the gate electrode 153 and the front metal 170 is reduced, and a cell size of the power device 100 can be effectively reduced in a horizontal direction. For example, compared with the existing structure in the background, this embodiment can reduce the cell size by 20%-30%, greatly reducing the area of the chip, thus increasing a number of chips produced on a single wafer by 20%.

Referring to FIG. 15, an embodiment of the present invention provides a power device 210, which includes, for example, a substrate 211, a semiconductor epitaxial layer 212, a control electrode 213, first conductivity type doped regions 214, second conductivity type doped regions 215, an electrode layer 216, and an insulating medium 217. The first conductivity type doped regions 214 and the second conductivity type doped regions 215 together constitute a doped region.

Specifically, the semiconductor epitaxial layer 212 is disposed on the substrate 211, and the semiconductor epitaxial layer 212 is provided with a trench 2121, and the trench 2121 is recessed from a top surface 212T of the semiconductor epitaxial layer 212 facing away from the substrate 211. The control electrode 213 is disposed in the trench 2121, which for example serves as a gate electrode. The first conductivity type doped regions 214 are disposed in the semiconductor epitaxial layer 212, and the trench 2121 is disposed between the first conductivity type doped regions 14 (in other words, the first conductivity type doped regions 214 are respectively located at opposite sides of the trench 2121), and a part of each of the first conductivity type doped regions 214 is located directly below the control electrode 213. The second conductivity type doped regions 215 are disposed in the semiconductor epitaxial layer 212, and located at sides of the first conductivity type doped regions 214 facing towards the trench 2121. Each of regions occupied by the second conductivity type doped regions 215 between the first conductivity type doped regions 214 and the trench 2121 is a stepped region, which extends from the top surface 212T of the semiconductor epitaxial layer 212 towards a bottom surface 212B of the semiconductor epitaxial layer 212 facing towards the substrate 211. A part of the stepped region is located directly below the control electrode 213. The electrode layer 216 is disposed on a side of the semiconductor epitaxial layer 212 facing away from the substrate 211 and forms ohmic contact with the first conductivity type doped region 214 and the second conductivity type doped region 215, respectively. For example, the electrode layer 216 serves as a source electrode. The insulating medium 217 fills the trench 2121 and insulates the control electrode 213 from the first conductivity type doped region 214, the second conductivity type doped region 215, the semiconductor epitaxial layer 212 and the electrode layer 216. In addition, it can be seen from FIG. 15 that in a direction R toward the trench 2121, channels 212C are formed by junction depth differences between the first conductivity type doped regions 214 and the second conductivity type doped regions 215, and the channels 212C are located directly below the control electrode 213.

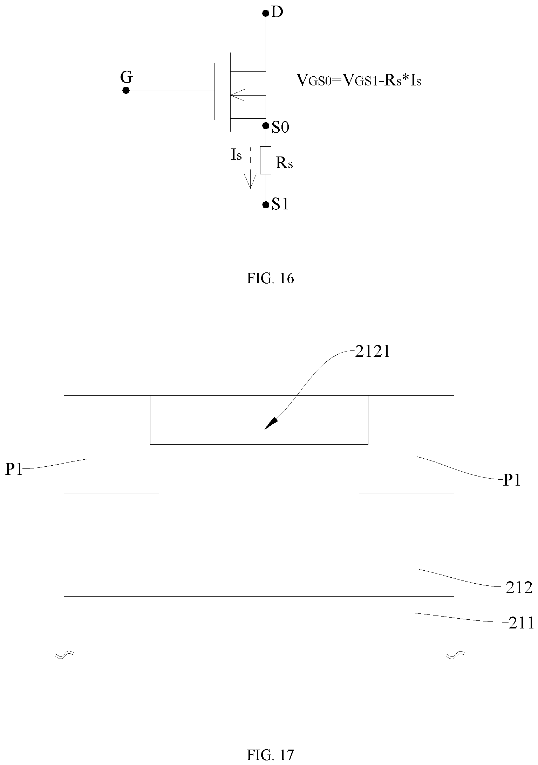

In this embodiment, by designing the second conductivity type doped region 215 between the first conductivity type doped region 214 and the trench 2121 as a step-like structure, such as the two-tiered steps shown in FIG. 15, the second conductivity type doped region 215 is formed as a narrow strip-like region, which is equivalent to a lower body resistor Rₛ connected in series between the electrode layer 216 and a boundary of the channel 212C, as shown in FIG. 16. The body resistor Rₛ has a positive temperature coefficient. Within a normal operating temperature range of the power device, a resistance of this body resistor Rₛ is relatively smaller and has a minimal impact on the normal operation of the power device. However, under a short-circuit withstand test condition, the power device's temperature significantly exceeds a normal operating temperature, thereby causing the resistance of this body resistor Rₛ to increase dramatically; and under a higher current condition (for example, more than 10 times the normal operating current) during the short-circuit withstand test condition, a voltage drop across this body resistor Rₛ increases sharply, causing a voltage-dividing phenomenon on a gate voltage, that is, V_{GSO}=V_{GS1} - R_{S} * Is, where V_{GS1} represents a gate-source voltage, V_{GSO} represents a gate voltage applied to a channel surface, and I_{S} represents a current. The voltage-dividing phenomenon results in a reduction of the gate voltage applied to the channel surface, thereby decreasing a concentration of inverted-layer charge carriers on the channel surface, increasing the resistance of the power device, and reducing a peak current under short-circuit withstand test condition, thereby enhancing the short-circuit tolerance of the power device. It should be noted that in FIG. 16, G represents the control electrode 213 (for example, the gate electrode), D represents the drain electrode, S1 represents the electrode layer 216 (for example, the source electrode), and S0 represents a position corresponding to the channel surface.

In some embodiments, as shown in FIG. 15, in the direction R toward the trench 2121, the stepped region sequentially includes a first lateral part 2151, a middle part 2152 and a second lateral part 2153. The middle part 2152 extends from the top surface 212T of the semiconductor epitaxial layer 212 toward the bottom surface 212B of the semiconductor epitaxial layer 212, which is, for example, an elongated straight strip, but the embodiment of the present invention is not limited to this, as long as the stepped region can include at least two steps. The first lateral part 2151 and the second lateral part 2153 are respectively connected with opposite ends of the middle part 2152 and located at opposite sides of the middle part 2152. A surface of the first lateral part 2151 facing away from the substrate 211 is a part of the top surface 212T of the semiconductor epitaxial layer 212, and the second lateral part 2153 is located directly below the trench 2121. A side surface 2153S of the second lateral part 2153 facing away from the first lateral part 2151 is a channel boundary, and the second conductivity type doped regions 215 are equivalent to a body resistor having a positive temperature coefficient connected in series between the electrode layer 216 and the channel boundary, such as the body resistor Rₛ shown in FIG. 16.

In some embodiments, as shown in FIG. 15, the stepped region includes a first stepped surface 2154S facing away from the trench 121 and a second stepped surface 2155S opposite to the first stepped surface 154S. The first stepped surface 2154S includes, for example, two stepped planes and a vertical plane connected between the two stepped planes. Similarly, the second stepped surface 2155S includes, for example, two stepped planes and a vertical plane connected between the two stepped planes, thereby making the second conductivity type doped region 215 roughly Z-shaped. A side surface 2153S of the second lateral part 2153 connects the first stepped surface 2154S and the second stepped surface 2155S and is disposed between the first stepped surface 2154S and the second stepped surface 2155S. A spacing d1 between the first stepped surface 2154S and the second stepped surface 2155S, for example, is 50 nanometers (nm) to 600 nanometers.

In some embodiments, as shown in FIG. 15, in the direction R toward the trench 2121, the first conductivity type doped region 214 sequentially includes a first ion implantation region 2141, a second ion implantation region 2142 and a third ion implantation region 2143. A doping concentration of the second ion implantation region 2142 is less than that of the first ion implantation region 2141 and greater than that of the third ion implantation region 2143. An interface BS between the second ion implantation region 2142 and the third ion implantation region 2143 is located directly below the trench 2121. Additionally, it can be seen from FIG. 15 that the second ion implantation region 2142 connects the first ion implantation region 2141 with the third ion implantation region 2143 and is disposed between the first ion implantation region 2141 with the third ion implantation region 2143. The second ion implantation region 2142 is roughly L-shaped and the third ion implantation region 2143 is also roughly L-shaped.

In some embodiments, as shown in FIG. 15, the insulating medium 217 includes a thermal oxide layer 2171 (also called as a gate oxide layer) and an interlayer dielectric layer 2173 (also called as a dielectric layer). The thermal oxide layer 2171 is located in the trench 2121 and insulates the control electrode 213 from the first conductivity type doped region 214, the second conductivity type doped region 215 and the semiconductor epitaxial layer 212, respectively. The interlayer dielectric layer 2173 is filled in the trench 2121 and is covered by the electrode layer 216, and the interlayer dielectric layer 2173 insulates the control electrode 213 from the electrode layer 216.

In some embodiments, as shown in FIG. 15, a top surface 2173T of the interlayer dielectric layer 2173 facing away from the substrate 211 is flush with a plane where a notch of the trench 2121 is located. In other embodiments, the top surface 2173T of the interlayer dielectric layer 2173 is lower than the plane where the notch of the trench 2121 is located, so that the electrode layer 216 correspondingly partially extends into the trench 2121.

In some embodiments, as shown in FIG. 15, the control electrode 213 includes a first electrode part 2131 and a second electrode part 2133, which are separated by the interlayer dielectric layer 2173, that is, the control electrode 213 is a split electrode. The thermal oxide layer 2171 covers two opposite side surfaces (or outer side surfaces) of the first electrode part 2131 and the second electrode part 2133 and bottom surfaces of the first electrode part 2131 and the second electrode part 2133 facing towards the substrate 211, so that each of the first electrode part 2131 and the second electrode part 2133 is insulated from the first conductivity type doped region 214, the second conductivity type doped region 215 and the semiconductor epitaxial layer 212. The interlayer dielectric layer 2173 covers two opposite side surfaces (or inner side surfaces) of the first electrode part 2131 and the second electrode part 2133 and top surfaces of the first electrode part 2131 and the second electrode part 2133 facing away from the substrate 211, so as to separate the first electrode part 2131 from the second electrode part 2133 and insulate each of the first electrode part 2131 and the second electrode part 2133 from the electrode layer 216. In addition, as can be seen from FIG. 15, a region between the first electrode part 2131 and the second electrode part 2133 exposes a part of the semiconductor epitaxial layer 212 between the channels 212C, and the first electrode part 2131 and the second electrode part 2133 completely cover their corresponding channels 212C, so as to ensure good control ability of the channels 212C. In this embodiment, the control electrode 213 includes the first electrode part 2131 and the second electrode part 2133 which are spaced apart from each other, that is, the split electrode is formed, which can reduce an overlapping area between the control electrode 213 and the semiconductor epitaxial layer 212 (the overlapping area is positively correlated with a Miller capacitance), thereby reducing a Miller capacitance (Cᵣₛₛ) per unit area, and further significantly reducing switching loss of the power device. At the same time, a ratio (Cᵢₛₛ/Cᵣₛₛ) of an input capacitance to the Miller capacitance per unit area is increased, which can better inhibit the power device from being turned on by crosstalk under higher di/dt working conditions, and further improve the reliability of the power device under higher di/dt working conditions.

In some embodiments, as shown in FIG. 15, the electrode layer 216 includes a contact metal layer 2161 and front metal layer 2163. The contact metal layer 2161 is located on a side of the semiconductor epitaxial layer 212 facing away from the substrate 211 and forms ohmic contact with the first conductivity type doped region 214 and the second conductivity type doped region 215. Specifically, the contact metal layer 2161 forms ohmic contact with the first ion implantation region 2141 of the first conductivity type doped region 214 and the first lateral part 2151 and the middle part 2152 of the second conductivity type doped region 215. The front metal layer 2163 is located on a side of the contact metal layer 2161 facing away from the semiconductor epitaxial layer 212 and covers the trench 2121 and the insulating medium 217. Furthermore, a side of the substrate 211 facing away from the semiconductor epitaxial layer 212 is provided with a back metal layer 218, for example, as a drain electrode.

In order to facilitate a clearer understanding of the power device 210 provided by the embodiment of the present invention, a manufacturing method of the power device 210 shown in FIG. 15 will be described with reference to FIG. 17 through FIG. 25, taking the first conductivity type as P-type and the second conductivity type as N-type as an illustrative example. The specific manufacturing method can include the following steps.

Referring to FIG. 17, a semiconductor epitaxial layer 212 is formed on a substrate 211, for example, an N- type SiC epitaxial layer is grown on an N+ type silicon carbide (SiC) substrate, and a growth mode may be a vapor phase epitaxial process. Subsequently, P type doped ion implantation regions P1 are locally implanted on a side of the semiconductor epitaxial layer 212 facing away from the substrate 211, and a trench 2121 is formed in the semiconductor epitaxial layer 212 by etching, where the trench 2121 is located between the ion implantation regions P1.

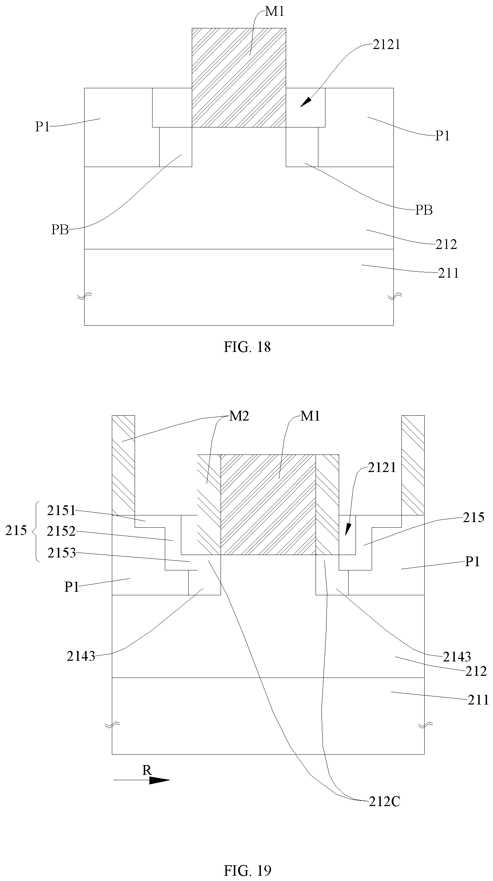

Referring to FIG. 18, an implantation mask M1 is formed in the trench 2121, and P- type ion implantation regions PB are formed by ion implantation, where each ion implantation region PB is located on a side of the ion implantation region P1 facing towards the trench 2121, and a doping concentration of the ion implantation region PB is smaller than that of the ion implantation region P1.

Referring to FIG. 19, a mask M2 is formed by photolithography and self-alignment, and elongated N+ type ion implantation regions are formed as second conductivity type regions 215 by ion implantation, and channels 212C and third ion implantation regions 2143 of the first conductivity type regions 214 are formed at the same time. Each second conductivity type region 215 sequentially includes a first lateral part 2151, a middle part 2152 and a second lateral part 2153 in the direction R toward the trench 2121. The middle part 2152 can be formed by ion implantation with an inclination angle. As can be seen from FIG. 19, the channels 212C are formed by junction depth differences in the direction R toward the trench 2121 between the second conductivity type regions 215 and the third ion implantation regions 2143. After that, the mask M2 is removed.

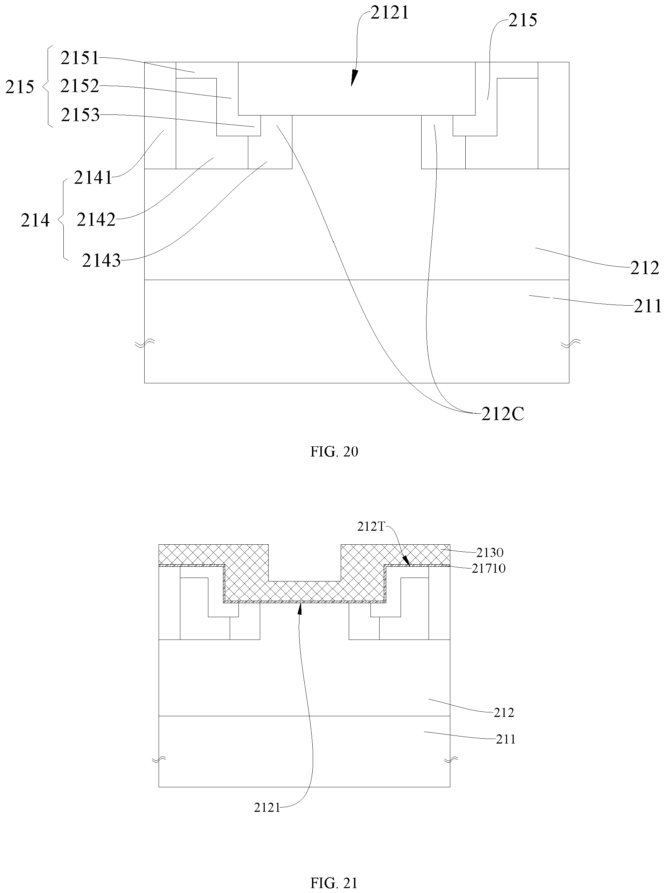

Referring to FIG. 20, P+ type ion implantation is locally performed on a side of the semiconductor epitaxial layer 212 facing away from the substrate 211 to convert the ion implantation regions P1 in FIG. 19 (including three steps, for example) into first ion implantation regions 2141 and second ion implantation regions 2142 of the first conductivity type regions 214. A doping concentration of the first ion implantation region 2141 is greater than that of the second ion implantation region 2142.

Referring to FIG. 21, a thermal oxidation material layer 21710 is formed on a top surface 212T of the semiconductor epitaxial layer 212 and a bottom surface and sidewalls of the trench 2121 by thermal oxidation, and a doped polysilicon layer 2130 is formed on a surface of the thermal oxidation material layer 21710 facing away from the substrate 211.

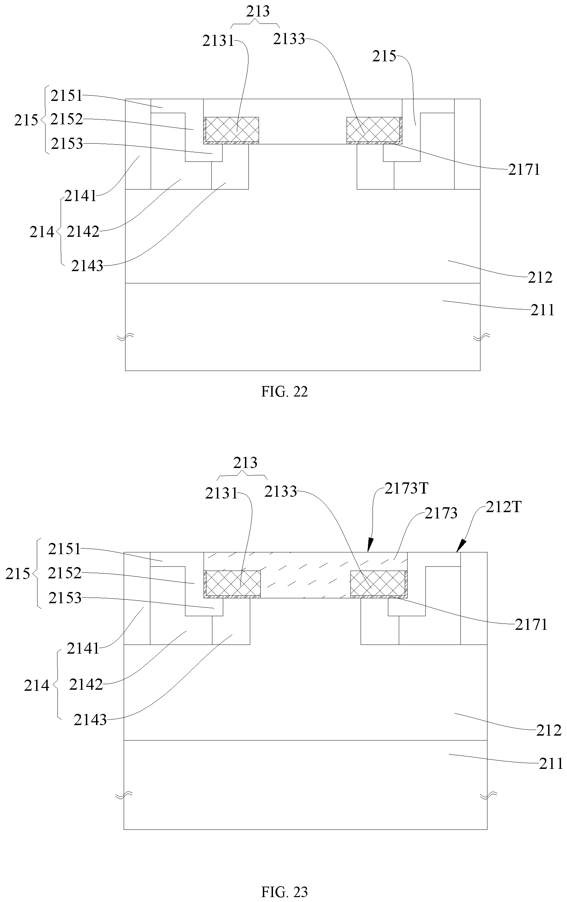

Referring to FIG. 22, a thermal oxide layer 21710 and a doped polysilicon layer 2130 are etched by self-alignment to form a thermal oxide layer 2171 and a control electrode 213. The control electrode 213 includes a first electrode part 2131 and a second electrode part 2133 which are spaced apart from each other, that is, the control electrode 213 is a split electrode. The thermal oxide layer 2171 covers two opposite side surfaces (or outer side surfaces) of the first electrode part 2131 and the second electrode part 2133 and bottom surfaces of the first electrode part 2131 and the second electrode part 2131 facing towards the substrate 211.

Referring to FIG. 23, an interlayer dielectric layer 2173 is formed by a deposition and etching process. A top surface 2173T of the interlayer dielectric layer 2173 is not higher than the top surface 212T of the semiconductor epitaxial layer 212 facing away from the substrate 211. Furthermore, the interlayer dielectric layer 2173 covers two opposite side surfaces (or left side surfaces) of the first electrode part 2131 and the second electrode part 2133 and top surfaces of the first electrode part 2131 and the second electrode part 2133 facing away from the substrate 211. In addition, it is worth mentioning that in an embodiment, the interlayer dielectric layer 2173 and the thermal oxide layer 2171 here together constitute an insulating medium 217.

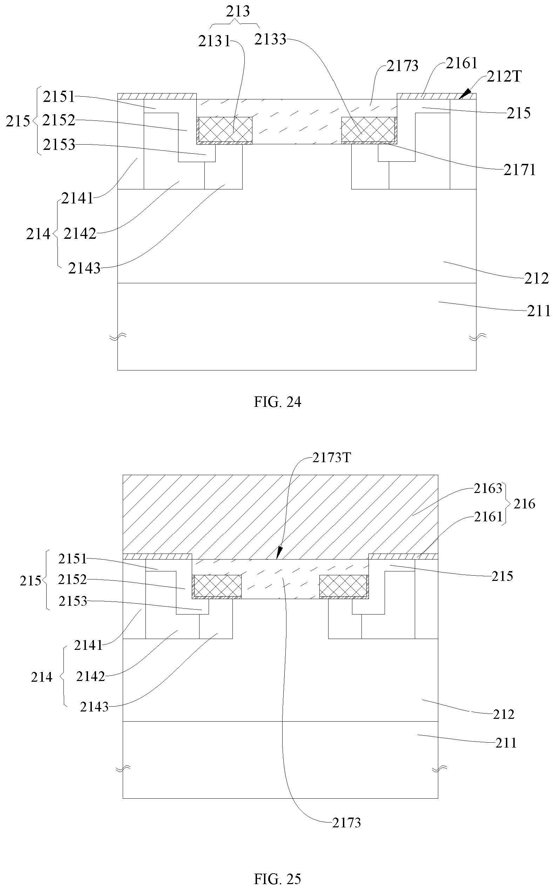

Referring to FIG. 24, an ohmic contact material layer (such as a Ti/Cu layer) is deposited on the top surface 212T of the semiconductor epitaxial layer 212, and then annealing and patterning are performed to obtain a contact metal layer 2161. The contact metal layer 2161 here forms good ohmic contact with the first ion implantation region 2141 of the first conductivity type region 214 and the first lateral part 2151 and the middle part 2152 of the second conductivity type region 215.

Referring to FIG. 25, a thickened metal material layer is deposited on a side of the contact metal layer 2161 facing away from the semiconductor epitaxial layer 212 and a top surface 2173T of the interlayer dielectric layer 2173, and then is etched and patterned to form front metal layer 2163. It is worth mentioning that in an embodiment, the front metal layer 2163 and the contact metal layer 2161 here together constitute the electrode layer 216.

Finally, a back surface of the substrate 211 facing away from the semiconductor epitaxial layer 212 is thinned and a back surface metal layer 218 is formed on the back surface, as shown in FIG. 15, so that the power device 210 shown in FIG. 15 can be manufactured.

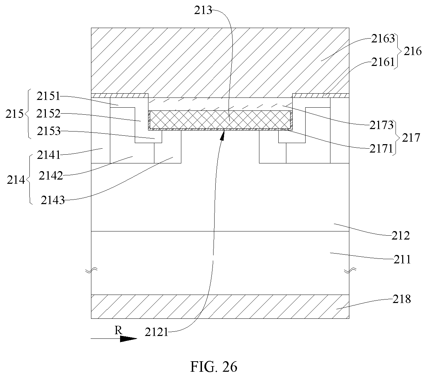

In addition, it is worth mentioning that when not considering the switching loss of the power device, the control electrode 213 can also be designed not as a split electrode. As shown in FIG. 26, the thermal oxidation layer 2171 covers two sides of the control electrode 213 and a bottom surface facing towards the substrate 211, to insulate the control electrode 213 from the first conductivity type doped region 214, the second conductivity type doped region 215, and the semiconductor epitaxial layer 212. The interlayer dielectric layer 2173 covers a top surface of the control electrode 213 facing away from the substrate 211, to insulate the control electrode 213 from the electrode layer 216. Moreover, the control electrode 213 completely covers the channels 212C, to ensure good control over the channels 212C.

The above is merely the specific embodiment of the present invention, but the scope of protection of the present invention is not limited to this, and any change or substitution that can be easily thought of by a person familiar with the technical field within the technical scope disclosed by the present invention should be included in the scope of protection of the present invention. Therefore, the scope of protection of the present invention should be based on the scope of protection of the appended claims.

## Claims

1. A power device, comprising:
a substrate;
a semiconductor epitaxial layer, disposed on the substrate, wherein a trench is defined in the semiconductor epitaxial layer, and the trench is recessed from a top surface of the semiconductor epitaxial layer facing away from the substrate; doped regions are formed in the semiconductor epitaxial layer and are disposed at two opposite sides of the trench; and the trench is at least partially embedded in the doped regions;
a gate electrode, configured to be buried in the trench;
an electrode layer, wherein the electrode layer is disposed on a side of the semiconductor epitaxial layer facing away from the substrate and forms ohmic contact with the doped regions; and
an insulating medium, configured to insulate the gate electrode from the doped regions and the semiconductor epitaxial layer;
wherein when the power device is in an on state, channels in the doped regions are configured as lateral conductive channels.

2. The power device as claimed in claim 1, wherein the gate electrode comprises a bottom surface facing away from the electrode layer, a top surface close to the electrode layer, and two opposite side surfaces connecting the top surface and the bottom surface of the gate electrode; and
wherein the insulating medium comprises a gate oxide layer and a dielectric layer, the dielectric layer and the gate oxide layer together surround the gate electrode, and the gate oxide layer covers the bottom surface and the two side surfaces of the gate electrode.

3. The power device as claimed in claim 2, wherein each side surface of the gate electrode comprises an arc segment, and the trench has a transition arc surface adapted to the arc surface segment.

4. The power device as claimed in claim 2 or 3, wherein a thickness of the gate oxide layer covering each side surface of the gate electrode is greater than a thickness of the gate oxide layer covering the bottom surface of the gate electrode.

5. The power device as claimed in any one of claims 2-3, wherein a surface of the insulating medium facing away from the substrate is flush with or lower than a plane where a notch of the trench is located.

6. The power device as claimed in claim 1, wherein the electrode layer comprises front metal and an ohmic contact layer, the front metal is disposed on the semiconductor epitaxial layer, the front metal extends into the trench and covers the insulating medium, and the ohmic contact layer is disposed between the front metal and the doped regions and extends onto a part of a sidewall of the trench.

7. The power device as claimed in claim 6, wherein a notch edge of the trench has an inclined surface, and the ohmic contact layer extends onto the inclined surface.

8. The power device as claimed in claim 1, wherein the doped regions comprise first conductivity type doped regions and second conductivity type doped regions, the trench is disposed between the first conductivity type doped regions, the second conductivity type doped regions are located at sides of the first conductivity type doped regions facing towards the trench, and a part of each of the first conductivity type doped regions is located directly below the gate electrode.

9. The power device as claimed in claim 8, wherein each of the second conductivity type doped regions is a stepped region extending from the top surface of the semiconductor epitaxial layer toward a bottom surface of the semiconductor epitaxial layer facing towards the substrate, and a part of the stepped region is located directly below the gate electrode.

10. The power device as claimed in claim 9, wherein the stepped region sequentially comprises a first lateral part, a middle part and a second lateral part in a direction towards the trench; the middle part extends from the top surface of the semiconductor epitaxial layer toward the bottom surface of the semiconductor epitaxial layer, the first lateral part and the second lateral part are respectively connected with opposite ends of the middle part and located at opposite sides of the middle part, a surface of the first lateral part facing away from the substrate is a part of the top surface of the semiconductor epitaxial layer, the second lateral part is directly below the trench, a side surface of the second lateral part facing away from the first lateral part is a channel boundary, and the second conductivity type doped region is equivalent to a body resistor with a positive temperature coefficient connected in series between the electrode layer and the channel boundary.

11. The power device as claimed claim 9, wherein the stepped region comprises a first stepped surface facing away from the trench and a second stepped surface opposite to the first stepped surface, and a side surface of the second lateral part is connected between the first stepped surface and the second stepped surface, and a spacing between the first stepped surface and the second stepped surface is 50 nm to 60 nm.

12. The power device as claimed in claim 8, wherein in a direction toward the trench, the channels are formed by junction depth differences between the first conductivity type doped regions and the second conductivity type doped regions, and the channels are located directly below the gate electrode.

13. A power device, comprising:
a substrate;
a semiconductor epitaxial layer, disposed on the substrate;
a first doped region and a second doped region, wherein the first doped region and the second doped region are disposed in the semiconductor epitaxial layer, the first doped region comprises a first base region and a first source region disposed in the first base region; and the second doped region comprises a second base region and a second source region disposed in the second base region;
a gate structure, comprising a trench, a gate electrode and an insulating medium, wherein the trench comprises a first bottom wall at least disposed on the first base region, a first sidewall connected with the first source region, a second bottom wall at least disposed on the second base region and a second sidewall connected with the second source region; the gate electrode is configured to be buried in the trench; the insulating medium is disposed in the trench, and the insulating medium is configured to insulate the gate electrode from the first doped region, the second doped region and the semiconductor epitaxial layer; and
front metal, disposed on the semiconductor epitaxial layer and covering the insulating medium, wherein the insulating medium insulates the gate electrode from the front metal, and an ohmic contact layer is disposed between the front metal and the first doped region and between the front metal and the second doped region.

14. A power device, comprising:
a substrate;
a semiconductor epitaxial layer, disposed on the substrate;
a first doped region and a second doped region, disposed in the semiconductor epitaxial layer;
a gate structure, comprising a trench, a gate electrode and an insulating medium, wherein the trench is defined between the first doped region and the second doped region and is partially embedded in the first doped region and the second doped region, the gate electrode is disposed to be buried in the trench, and the insulating medium is configured to insulate the gate electrode from the first doped region, the second doped region and the semiconductor epitaxial layer; and
front metal, disposed on the semiconductor epitaxial layer and covering the insulating medium, wherein the insulating medium is configured to insulate the gate electrode from the front metal, and an ohmic contact layer is disposed between the front metal and the first doped region and between the front metal and the second doped region;
wherein the insulating medium comprises a gate oxide layer disposed between the gate electrode and the trench, and a projection of the gate oxide layer on a top surface of the semiconductor epitaxial layer is connected with a projection of the ohmic contact layer on the top surface of the semiconductor epitaxial layer.

15. The power device as claimed in claim 14, wherein the trench comprises sidewalls and a bottom wall, and the sidewalls and a part of the bottom wall of the trench are configured to be embedded in the first doped region and the second doped region; and/or,
wherein the projection of the gate oxide layer on the top surface of the semiconductor epitaxial layer is adjacent to the projection of the ohmic contact layer on the top surface of the semiconductor epitaxial layer, and a spacing between the projection of the gate oxide layer on the top surface of the semiconductor epitaxial layer and the projection of the ohmic contact layer on the top surface of the semiconductor epitaxial layer is zero.
